# EUROPEAN PATENT APPLICATION

(11) **EP 4 576 958 A1**
(43) Date of publication of application: **25.06.2025**
(21) Application number: 23877637.1
(22) Date of filing: 11.10.2023
(51) Int. Cl.: H05K 7/14, H05K 9/00

(54) **CIRCUIT BOARD COUPLING STRUCTURE**

(30) Priority: 13.10.2022 KR 20220131857
(71) Applicant: LG Energy Solution, Ltd., Seoul 07335 (KR)
(72) Inventor: SHIN, Seung Won, Daejeon 34122 (KR)
(74) Representative: Goddar, Heinz J.
(86) International application number: PCT/KR2023/015551
(87) International publication number: WO 2024/080710

(57) **Abstract**

The present invention relates to a circuit board coupling structure, and more particularly, to a circuit board coupling structure including: a circuit board including an asymmetric part having one edge that is asymmetric with each of other edges; and a guide case coupled to the circuit board, wherein the guide case includes: a support plate that supports a lower portion of the circuit board; and a guide unit disposed on one surface of the support plate in a direction corresponding to a direction in which the asymmetric part is disposed.

## Description

### TECHNICAL FIELD

The present application claims the benefit of the priority of Korean Patent Application No. 10-2022-0131857, filed on October 13, 2022, which is hereby incorporated by reference in its entirety.

The present invention relates to a circuit board coupling structure, and more particularly, to a coupling structure for assembling a circuit board.

### BACKGROUND ART

Printed circuit boards (PCB) are necessary parts used for almost every electronic equipment, and are printed circuit boards that are wired and provided on insulation plates so as to circuitally connect electric/electronic components. The PCBs each have a structure in which a conductor and an insulator are stacked in the form of a board, and a plurality of electric/electronic components such as semiconductors, capacitors, or resistors may be mounted thereon. The mounted electric/electronic components may be electrically connected to each other through an electric line circuit printed on the PCB. In the PCB, electric lines may be efficiently designed to reduce a size of an electronic equipment, and to improve performance and productivity thereof.

The plurality of electric/electronic components mounted on the PCB may transmit or receive electrical signals. However, when an amount of electrical signals to be transmitted or received increases or high-speed processing of signals is required, a phenomenon in which a signal processing speed is decreased occurs, and this causes performance degradation of the PCB. In order to resolve the decrease in signal processing speed, methods such as a method of increasing the number of layers of the PCB to increase accommodating capacity for the components, are used.

In an assembly process of mounting the electric/electronic components on the PCB, it is important to dispose the PCB properly for assembling the electric/electronic components on the PCB in a designed direction. When the PCB is disposed in a direction opposite to the designed direction, or disposed to be inclined by a small angle, the electric/electronic components to be mounted on the PCB may be mounted in an unintended direction or mounted at an unintended position to cause a problem that collision between electrical signals transmitted or received between the assembled electric/electronic components of the completely assembled PCB occurs to cause the PCB not to function properly.

In addition, the PCB requires a signal ground to set a signal voltage reference point of the electrical signals transmitted or received between the electric/electronic components mounted on the PCB. Introduction of noise into the electrical signals transmitted or received between the electric/electronic components mounted on the PCB may be reduced through the signal ground. However, when the PCB is fixed using a rotating screw in the assemble process of the PCB, there may be problems that the PCB is inclined by a small angle due to torque of the rotating screw, and a connection for the signal ground is lost.

Accordingly, there is a need for technical development to solve the problems as above.

### DISCLOSURE OF THE INVENTION

### TECHNICAL PROBLEM

An object of the present invention for solving the above problems is to provide a circuit board coupling structure in which one edge of a circuit board is provided to be asymmetric with each of other edges of the circuit board so that during an assembly process of assembling an electronic component on the circuit board, the circuit board coupling structure is capable of intuitively determining whether the circuit board is disposed in a predetermined direction, and performing position-fixing and signal-grounding of the circuit board on a guide case at once.

### TECHNICAL SOLUTION

As one embodiment of the present invention, the present invention provides a circuit board coupling structure including: a circuit board including an asymmetric part having one edge that is asymmetric with each of other edges; and a guide case coupled to the circuit board, wherein the guide case includes: a support plate that supports a lower portion of the circuit board; and a guide unit disposed on one surface of the support plate in a direction corresponding to a direction in which the asymmetric part is disposed.

The edge of the asymmetric part may be provided in a direction diagonal to another edge adjacent thereto.

The guide unit may include a guide part having a shape corresponding to a shape of the asymmetric part, and the asymmetric part may be in contact with the guide part.

The guide part may extend in a direction perpendicular to one surface of the support plate.

The guide unit may further include a contact part extending in one direction of the guide part, and the asymmetric part may be in contact with the contact part while being fitted and coupled between the contact part and the support plate.

The guide unit may include an electrically conductive material, a ground pattern that grounds the circuit board may be defined in a top surface of the asymmetric part, and the ground pattern and the contact part may be electrically connected to each other.

The guide unit may further include an elastic clip protruding from a bottom surface of the contact part, and the elastic clip may be made of an elastically deformable metal material. When the asymmetric part is coupled to the guide unit, an end of the elastic clip may be in contact with the ground pattern while being elastically deformed in a direction in which the asymmetric part is coupled.

The contact part may be made of an elastically deformable metal material, and include a pressing part having a shape that is convex downward, and an inducing part extending from the pressing part in a distal direction, and having an inclination that is inclined upward toward an end thereof.

The contact part may have one edge that is coupled to one edge of the guide part through a hinge, and the hinge may include a spring coupled to a rotary shaft of the hinge, and having one end fixed to the guide part and the other end fixed to the contact part.

The spring may be spirally coupled to the rotary shaft in a longitudinal direction of the rotary shaft, and the one end of the spring may extend in one direction of the spring, and the other end of the spring may extend in the other direction of the spring.

The circuit board coupling structure may further include a coupling unit that couples the contact part to the circuit board.

A first coupling hole having an inner surface coated with an electrically conductive metal material may be defined on the ground pattern, and a second coupling hole may be coupled to the coupling unit, and defined in the contact part at a position corresponding to a position of the first coupling hole. The coupling unit may be coupled to the first coupling hole and the second coupling hole.

The circuit board may be capable of being separated from and coupled to the guide case.

### ADVANTAGEOUS EFFECTS

In the present invention, the shape of one edge of the circuit board may be provided to be asymmetric with the shape of the other edge so that in the assembly process of assembling the electronic component on the circuit board, whether the circuit board is disposed in the predetermined direction may be intuitively determined based on the position of the asymmetric part edge shape. Accordingly, the electronic components may be prevented in advance from being assembled in the unintended direction due to the circuit board arrangement error in the assembly process.

In addition, the present invention may fix the circuit board to the guide case, which is subject to being coupled to the circuit board, at a time so as to easily assemble the electronic components on the circuit board, and simultaneously may ground the circuit board to improve the efficiency of the assembly process. Moreover, the asymmetric part of the circuit board may have the ground pattern having the large area so that the contact area with the guide unit is increased to improve the grounding function.

### BRIEF DESCRIPTION OF THE DRAWINGS

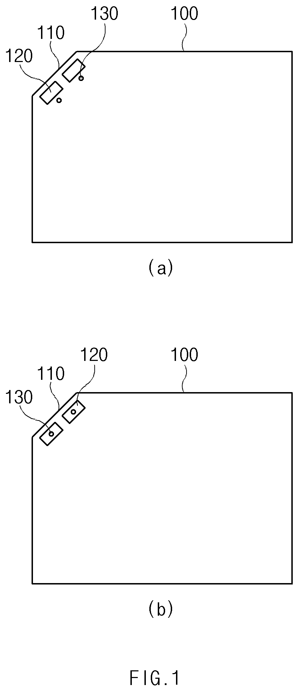

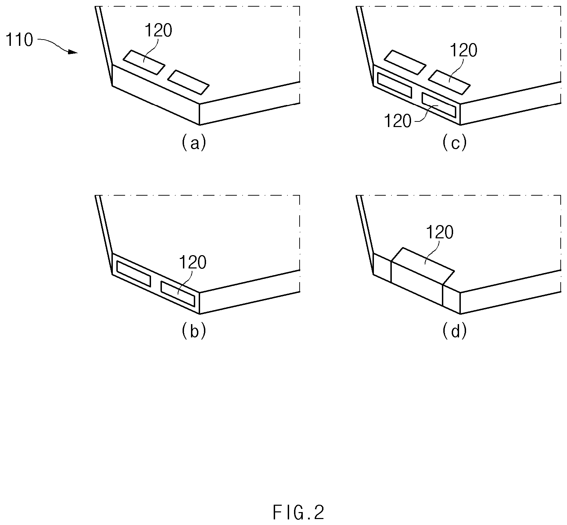

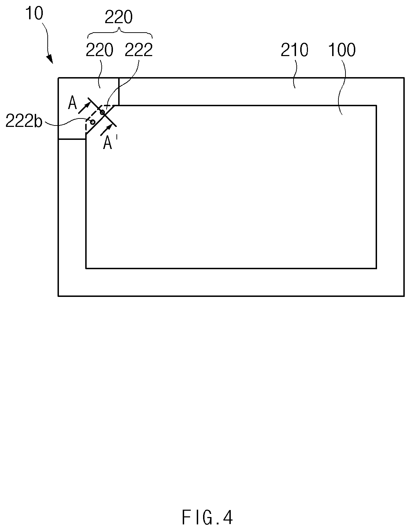

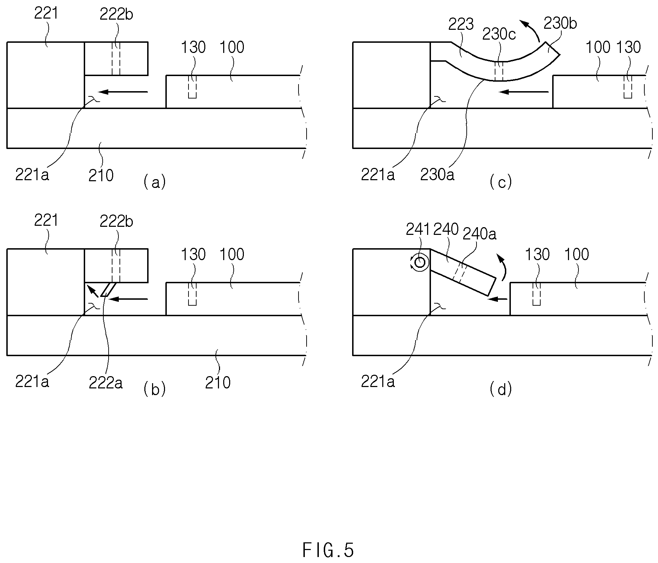

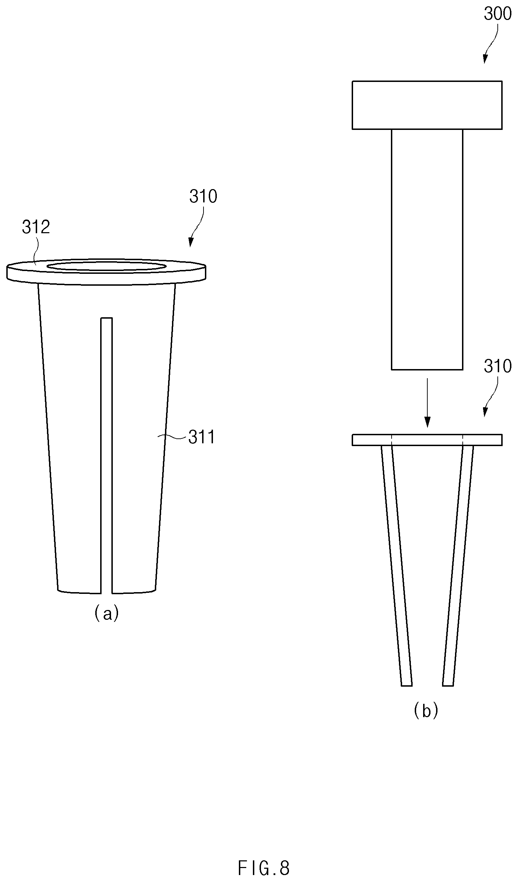

(a) and (b) of FIG. 1 are schematic plan views illustrating examples of a position of a first coupling hole and a shape of a circuit board according to an embodiment of the present invention.
(a) to (d) of FIG. 2 are perspective views illustrating various examples of a ground pattern defined in an asymmetric part of a circuit board according to an embodiment of the present invention.
FIG. 3 is a schematic plan view illustrating a configuration of a guide case according to the present invention.
FIG. 4 is a schematic plan view illustrating a configuration in which a circuit board is coupled to a guide case according to the present invention.
(a) of FIG. 5 is a schematic cross-sectional view taken along a line AA' in FIG. 4, illustrating a configuration in which the circuit board is coupled to the guide case, and one example of a contact part. (b) to (d) of FIG. 5 are schematic cross-sectional view illustrating a configuration in which the circuit board is coupled to the guide case, and other examples of a contact part, at the same position as that on a cross-section illustrated in (a) above.

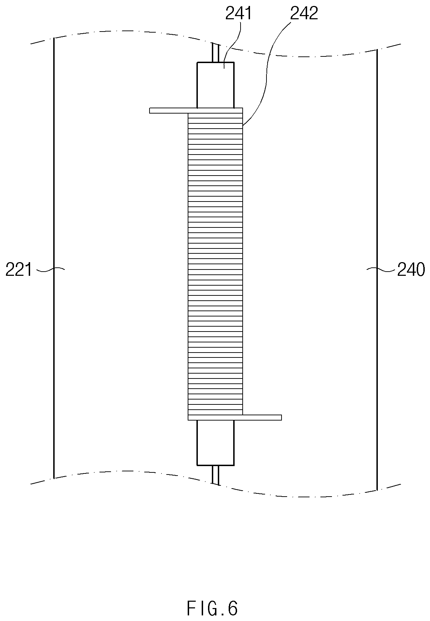

FIG. 6 is a schematic plan view illustrating a configuration in which the contact part is coupled to a guide part through a hinge according to the present invention in (d) of FIG. 5.

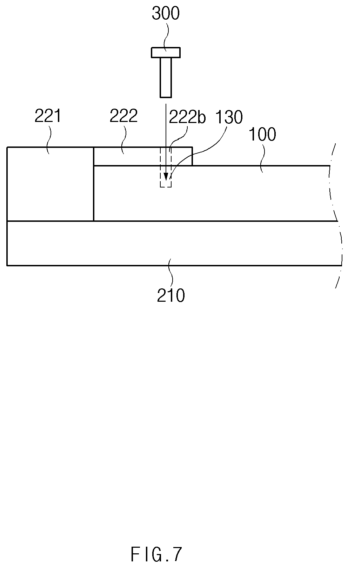

FIG. 7 is a schematic cross-sectional view taken along a line AA' in FIG. 4, illustrating a configuration in which the circuit board is coupled to the guide case through a coupling unit according to the present invention.
(a) and (b) of FIG. 8 are exploded views illustrating a shape of a tightening unit and a configuration in which a coupling unit is coupled to the tightening unit.

### MODE FOR CARRYING OUT THE INVENTION

Hereinafter, preferred embodiments of the present invention will be described in detail with reference to the accompanying drawings to enable those skilled in the art to which the present invention pertains to easily carry out the present invention. The present invention may, however, be embodied in different forms and should not be construed as limited by the embodiments set forth herein.

The parts unrelated to the description, or the detailed descriptions of related well-known art that may unnecessarily obscure subject matters of the present invention, will be ruled out in order to clearly describe the present invention. Like reference numerals refer to like elements throughout the whole specification.

Moreover, terms or words used in this specification and claims should not be restrictively interpreted as ordinary meanings or dictionary-based meanings, but should be interpreted as meanings and concepts conforming to the scope of the present invention on the basis of the principle that an inventor can properly define the concept of a term to describe and explain his or her invention in the best ways.

### Circuit board coupling structure 10

As one embodiment of the present invention, a circuit board coupling structure 10 according to the present invention may include a circuit board 100 and a guide case 200.

The circuit board 100 may include various types of circuit boards, for example, a printed circuit board (PCB), a flexible printed circuit board (FPCB), a rigid-flexible printed circuit board (RF-PCB), or a high density interconnection (HDI), and may be preferably a PCB. However, the circuit board 100 is not limited thereto.

Referring to (a) and (b) of FIG. 1, the circuit board 100 may be provided in the form of a plate, and have an asymmetric shape. The circuit board 100 may include an asymmetric part 110, a ground pattern 120, and a first coupling hole 130.

The circuit board 100 may include the asymmetric part 110 on one edge portion thereof to cause the circuit board 100 to appear to be asymmetric.

The asymmetric part 110 may be provided in the form of a linear edge in a direction diagonal to each of other edges adjacent thereto, and may be provided to be asymmetric with a vertex or an edge part of the circuit board 100, which is disposed in the direction diagonal to the asymmetric part 110.

The asymmetric part 110 may have a shape different from that of each of vertexes of the circuit board 100, which are disposed on ends of the edges adjacent to the asymmetric part 110.

Due to the asymmetric part 110, whether the circuit board 100 is disposed at a predetermined direction may be immediately checked when electronic components are assembled on the circuit board 100. The asymmetric part 110 may be provided on only one of the edges of the circuit board 100, and provided only in a predetermined direction. Thus, when the circuit board 100 is rotated 180 degrees around an axis perpendicular to one surface thereof, a worker may locate the asymmetric part 110 to correct an arrangement of the circuit board 100 so that the asymmetric part 110 is disposed in the predetermined direction.

Referring to (a) to (d) of FIG. 2, the ground pattern 120 may be defined in the asymmetric part 110.

The ground pattern 120 may be a component for signal-grounding the circuit board 100 to reduce noise such as electromagnetic interference (EMI) or electro static discharge (ESD), which is a factor that deteriorates performance of the circuit board 100, and generate a reference voltage of a signal transmitted and received between the electronic components mounted on the circuit board 100.

The ground pattern 120 may be provided to have a predetermined area and in a predetermined number on a top surface or a side surface of the asymmetric part 110 so that a contact area between the ground pattern 120 and the guide unit 220 is increased to improve a grounding function.

Referring to (a) of FIG. 2, as one embodiment, the ground pattern 120 may be defined in the top surface of the asymmetric part 110. The circuit board 100 may be coupled to the guide case 200, and a guide unit 220 of the guide case 200 to be described later and the asymmetric part 110 may be coupled to each other. The ground pattern 120 defined in the top surface of the asymmetric part 110 may be in contact and electrically connected to a bottom surface of a contact part 222 of the guide unit 220, and the circuit board 100 may be grounded.

Referring to (b) of FIG. 2, as another embodiment, the ground pattern 120 may be defined in one end of the asymmetric part 110. When the circuit board 100 is coupled to the guide case 200, the one end of the asymmetric part 110 may be in contact with a guide part 221 of the guide unit 220 having a shape corresponding to a shape of the asymmetric part 110.

Referring to (c) of FIG. 2, as still another embodiment, the ground pattern 120 may be defined in each of the top surface and the one end of the asymmetric part 110. As the ground pattern 120 is defined in each of the one end and the top surface that are in contact with the guide unit, a contact area between the ground pattern 120 and the guide unit may be increased.

Referring to (d) of FIG. 2, as still another embodiment, the ground pattern 120 may be defined to extend from the top surface to the one end of the asymmetric part 110. The area of the ground pattern 120 may be increased to increase the contact area with the guide unit 220, and improve the signal grounding function of the circuit board 100.

The ground pattern 120 may include an electrically conductive metal material so as to be electrically connected to the guide unit 220. The metal material may be, for example, copper, gold, silver, aluminum, or the like, but is not limited thereto.

The first coupling hole 130 that is a groove passing through the circuit board 100 or having a predetermined depth may be defined in the circuit board 100. A coupling unit 300 to be described later may be coupled to the first coupling hole 130.

Referring to (a) and (b) of FIG. 1, for example, the first coupling hole 130 may be defined on the ground pattern 120, or in a position spaced a predetermined distance from the ground pattern 120, but the position of the first coupling hole 130 is not limited thereto.

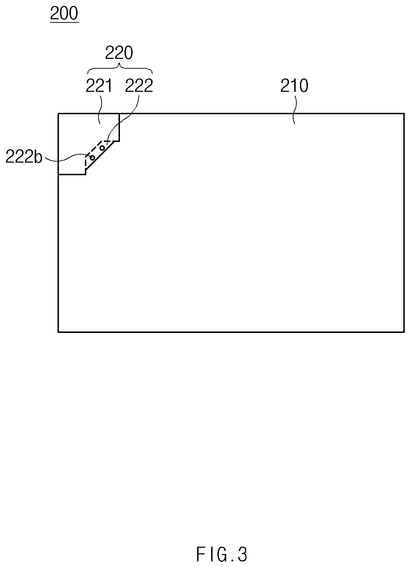

Referring to FIGS. 3 and 4, the guide case 200 may be coupled to the circuit board 100 to signal-ground the circuit board 100, and may support and fix the circuit board 100 so that an electronic component is easily mounted on the circuit board 100. The circuit board 100 may be capable of being coupled to and separated from the guide case 200.

The guide case 200 may include a support plate 210 and the guide unit 220.

The support plate 210 may be provided in the form of a plate having an area that is larger than an area of the top surface of the circuit board 100. When the circuit board 100 is coupled to the guide unit 220, the support plate 210 may support a lower portion of the circuit board 100.

The guide unit 220 may be disposed on the support plate 210.

The guide unit 220 may be coupled to the asymmetric part 110 of the circuit board 100. A position at which the guide unit 220 is disposed on the support plate 210 may correspond to a direction in which the asymmetric part 110 is disposed on the circuit board 100. That is, the guide unit 220 may be disposed on the support plate 210 to be biased in a direction in which one vertex of the support plate 210 is positioned.

The guide unit 220 may include an electrically conductive metal material so as to be electrically connected to the ground pattern 120. The metal material may be, for example, copper, gold, silver, aluminum, or the like, but is not limited thereto. Each of the guide part 221 and the contact part 222 that are include in the guide unit 220 may also be made of an electrically conductive metal material.

As the guide unit 220 is also signal-grounded, the guide unit 220 may be electrically connected to the ground pattern 120 to signal-ground an electric circuit board 100.

The guide unit 220 may include the guide part 221 and the contact part 222.

The guide part 221 may have an inner surface having a shape that corresponds to a shape of each of a front surface and a side surface of the asymmetric part 110. In the guide part 221, when the circuit board 100 is coupled to the guide case 200, the asymmetric part 110 may be guided along the inner surface of the guide part 221 to be seated on a seating part 221a provided inside the guide part 221. The position of the circuit board 100 on the support plate 210 may be fixed by the asymmetric part 110 seated on the guide part 221. As the position of the circuit board 100 is fixed on the support plate 210 as above, when each of contact parts 222, 230 and 240 and the circuit board 100 are subsequently coupled to each other through the coupling unit 300, movement of the circuit board 100 may be reduced, and the coupling may be easily performed.

The guide part 221 may extend in a direction perpendicular to one surface of the support plate 210. The guide part 221 may extend to have a height that is the same as or greater than a thickness of the circuit board 100.

Referring to (a) to (d) of FIG. 5, the contact part 222 may be a component that extends from a top surface or one side of the guide part 221 in one direction to be in contact with a ground pattern 120 provided on the top surface of the asymmetric part 110.

Referring to (a) of FIG. 5, as one embodiment, the contact part 222 may extend from an upper portion or the one side of the guide part 221 toward a direction in which the asymmetric part 110 is coupled to the guide part 221. Here, the contact part 222 may have a shape fixed to the guide part 221, and a spaced distance between the contact part 222 and the support plate 210 may be the same as a thickness of the asymmetric part 110, or be a little less than the thickness of the asymmetric part 110. When the asymmetric part 110 slides on the support plate 210 toward a direction, in which the guide unit 220 is disposed, in order to be coupled to the guide unit 220, the asymmetric part 110 may be press-fitted and coupled into a space between the contact part 222 and the support plate 210, and the contact part 222 and the guide part 221 may be in contact with and electrically connected to the ground pattern 120 of the asymmetric part 110.

Referring to (b) of FIG. 5, as another embodiment, an elastic clip 222a may be coupled to the contact part 222. The elastic clip 222a may be coupled to protrude from a bottom surface of the contact part 222, and may have an inclination that is inclined in a direction in which the asymmetric part 110 is coupled to the guide unit 220. The elastic clip 222a may be made of a metal material capable of being elastically deformed in an elastic deformation range, and the metal material may be, for example, copper, gold, silver, aluminum, iron, zinc, or the like. When the asymmetric part 110 is introduced into the seating part 221a, the elastic clip 222a may be elastically deformed by force of the asymmetric part 110 pushing the elastic clip 222a in a direction in which the asymmetric part 110 is coupled, and the elastic clip 222a may be in contact with and electrically connected to the ground pattern 120 provided on the top surface of the asymmetric part 110. The elastic clip 222a may be provided in one or more.

The elastic clip 222a may be provided to have a predetermine width and length, and have a thickness that is relatively small compared to each of the width and the length.

Referring to (c) of FIG. 5, as still another embodiment, the contact part 230 may extend from the upper portion or the one side of the guide part 221 toward a direction in which the asymmetric part 110 is coupled to the guide part 221, and may be made of an electrically conductive metal material capable of being elastically deformed in an elastic deformation range. The contact part 230 may include a pressing part 230a and an inducing part 230b.

The pressing part 230a may have a shape that is convex downward, and when the asymmetric part 110 is coupled to the guide part 221, the lowest point of the pressing part 230a may be in contact with the ground pattern 120 of the asymmetric part 110 while pressing the ground pattern 120.

The inducing part 230b may extend from the pressing part 230a in a distal direction at a distal end of the contact part 230 so as to have an inclination that is inclined upward toward an end thereof. When the asymmetric part 110 slides in a direction in which the guide part 221 is disposed, the inducing part 230b may be in contact with the asymmetric part 110, and the asymmetric part 110 may move while pushing the inducing part 230b up. Accordingly, the inclination provided on the inducing part 230b may be deformed to be steeper and steeper. When the inclination of the inducing part 230b is deformed to be steeper and steeper, the pressing part 230a may be electrically connected to the ground pattern 120 while pressing the top surface of the asymmetric part 110 due to elastic restoring force.

Referring to (d) of FIG. 5 and FIG. 6, as still another embodiment, one edge of the contact part 240 may be coupled to one edge part of the guide part 221 through a hinge 241. The contact part 240 may rotate around a rotary shaft of the hinge 241. The hinge may include a spring 242 in the form of a coil that spirally winds and is coupled to the rotary shaft in a longitudinal direction of the rotary shaft. One end and the other end of the spring 242 may extend along a spiral in one and the other directions of the spring 242, respectively. The one end may be fixed to the top surface of the guide part 221, and the other end may be fixed to a top surface of the contact part 240. When the contact part 240 rotates in a direction in which a distal end of the contact part 240 is away from the support plate 210, the spring 242 may apply elastic force so that the one end fixed to the guide part 221 rotates in the same direction as the rotation direction of the contact part 240, and the other end fixed to the contact part 240 rotates again in a direction opposite to the rotation direction of the contact part 240. When the asymmetric part 110 approaches the guide unit 220 to be coupled to the guide unit 220, the distal end of the contact part 240 may be rotated in the direction, which is away from the support plate 210, to define a space in which the asymmetric part 110 is capable of being coupled to the guide part 221. After the asymmetric part 110 is coupled to the guide part 221, due to the elastic force of the spring 242, the contact part 240 may be in contact with and electrically connected to the ground pattern 120 defined on the top surface of the asymmetric part 110.

The circuit board coupling structure 10 may further include the coupling unit 300.

Referring to FIG. 7, the coupling unit 300 may fix and couple each of the contact parts 222, 230 and 240 and the circuit board 100 to each other so that the circuit board 100 is completely fixed on the guide case 200.

The first coupling hole 130 may be defined in the circuit board 100, and second coupling holes 222b, 230c and 240a may be defined in the contact parts 222, 230 and 240, respectively. The first coupling hole 130 and each of the second coupling holes 222b, 230c and 240a may be coupled through the coupling unit 300.

As one embodiment, the first coupling hole 130 may be defined in a position spaced a predetermined distance from the ground pattern 120, and each of the second coupling holes 222b, 230c and 240a may be defined in a position corresponding to the first coupling hole 130. The coupling unit 300 may be inserted and coupled to the first coupling hole 130 and each of the second coupling holes 222b, 230c and 240a so as to couple each of the contact parts 222, 230 and 240 to the circuit board 100.

As another embodiment, the first coupling hole 130 may be defined on the ground pattern 120 of the asymmetric part 110, and each of the second coupling holes 222b, 230c and 240a may be defined in a position corresponding to the first coupling hole 130. Accordingly, the first coupling hole 130 may be coupled to each of the second coupling holes 222b, 230c and 240a through the coupling unit 300. An inner surface of the first coupling hole 130 may be coated with the same electrically conductive metal material as the material of the ground pattern 120 along a circumference thereof, and the coated inner surface may be connected to the ground pattern 120. The second coupling holes 222b, 230c and 240a may be made of the same electrically conductive metal materials as the contact parts 222, 230 and 240, respectively. As the coupling unit 300 is also made of an electrically conductive metal material, the first coupling hole 130 and each of the second coupling holes 222b, 230c and 240a may be electrically connected through the coupling unit 300 coupled to the first coupling hole 130 and each of the second coupling holes 222b, 230c and 240a.

Referring to FIG. 8, as still another embodiment, the coupling unit 300 may include a tightening unit 310 coupled to the coupling unit 300. The tightening unit 310 may include a body part 311 and a flange 312. An opening portion may be defined in each of a top surface and a bottom surface of the body part 311, and a hollow may be defined therein so that the top surface, the bottom surface, and the hollow communicate with each other. The body part 311 may have a cylindrical shape, and may have a cross-sectional area that gradually decreases from the top surface to the bottom surface. A slit groove 311a may be defined in body part 311 so as to be elongated in a longitudinal direction of the body part 311. When the tightening unit 310 is inserted into the first coupling hole 130 and each of the second coupling holes 222b, 230c and 240a, and the coupling unit 300 is coupled through the opening portion defined in the top surface of the body part 311, the coupling unit 300 may widen a gap of the slit groove 311a, and the body part 311 may be in close contact with the first coupling hole 130 and each of the second coupling holes 222b, 230c and 240a. The tightening unit 310 may be made of a plastically deformable metal having electrical conductivity so as to be easily changed in shape. The flange 312 may be bent outward from an upper end of the body part 311.

Although the present invention has been described with reference to the limited embodiments and drawings, the present invention is not limited thereto and may be variously implemented by those of ordinary skill in the art to which the present invention pertains, within the technical idea of the present invention and an equivalent of the appended claims.

### [Description of the Symbols]

10: Circuit board coupling structure
100: Circuit board
110: Asymmetric part
120: Ground pattern
130: First coupling hole
200: Guide case
210: Support plate
220: Guide unit
221: Guide part
221a: Seating part
222, 230, 240: Contact part
222a: Elastic clip
222b, 230c, 240a: Second coupling hole
230a: Pressing part
230b: Inducing part
241: Hinge
242: Spring
300: Coupling unit
310: Tightening unit

## Claims

1. A circuit board coupling structure comprising:
a circuit board comprising an asymmetric part having one edge that is asymmetric with each of other edges; and
a guide case coupled to the circuit board,
wherein the guide case comprises:
a support plate configured to support a lower portion of the circuit board; and
a guide unit disposed on one surface of the support plate in a direction corresponding to a direction in which the asymmetric part is disposed.

2. The circuit board coupling structure of claim 1, wherein the edge of the asymmetric part is provided in a direction diagonal to another edge adjacent thereto.

3. The circuit board coupling structure of claim 2, wherein the guide unit comprises a guide part having a shape corresponding to a shape of the asymmetric part,
wherein the asymmetric part is in contact with the guide part.

4. The circuit board coupling structure of claim 3, wherein the guide part extends in a direction perpendicular to one surface of the support plate.

5. The circuit board coupling structure of claim 3, wherein the guide unit further comprises a contact part extending in one direction of the guide part,
wherein the asymmetric part is in contact with the contact part while being fitted and coupled between the contact part and the support plate.

6. The circuit board coupling structure of claim 5, wherein the guide unit comprises an electrically conductive material, and
a ground pattern configured to ground the circuit board is defined in a top surface of the asymmetric part,
wherein the ground pattern and the contact part are electrically connected to each other.

7. The circuit board coupling structure of claim 6, wherein the guide unit further comprises an elastic clip protruding from a bottom surface of the contact part,
wherein the elastic clip is made of an elastically deformable metal material, and
when the asymmetric part is coupled to the guide unit, an end of the elastic clip is in contact with the ground pattern while being elastically deformed in a direction in which the asymmetric part is coupled.

8. The circuit board coupling structure of claim 6, wherein the contact part is made of an elastically deformable metal material, and comprises:
a pressing part having a shape that is convex downward; and
an inducing part extending from the pressing part in a distal direction, and having an inclination that is inclined upward toward an end thereof.

9. The circuit board coupling structure of claim 6, wherein the contact part has one edge that is coupled to one edge of the guide part through a hinge,
wherein the hinge comprises a spring coupled to a rotary shaft of the hinge, and having one end fixed to the guide part and the other end fixed to the contact part.

10. The circuit board coupling structure of claim 9, wherein the spring is spirally coupled to the rotary shaft in a longitudinal direction of the rotary shaft, and
the one end of the spring extends in one direction of the spring, and the other end of the spring extends in the other direction of the spring.

11. The circuit board coupling structure of claim 5, further comprising a coupling unit configured to couple the contact part to the circuit board.

12. The circuit board coupling structure of claim 11, wherein a first coupling hole having an inner surface coated with an electrically conductive metal material is defined on the ground pattern, and
a second coupling hole is coupled to the coupling unit, and defined in the contact part at a position corresponding to a position of the first coupling hole,
wherein the coupling unit is coupled to the first coupling hole and the second coupling hole.

13. The circuit board coupling structure of claim 1, wherein the circuit board is capable of being separated from and coupled to the guide case.
